(19) Europäisches Patentamt
European Patent Office
Office européen des brevets

(11) **EP 4 432 036 B1**

(12) **FASCICULE DE BREVET EUROPEEN**

(45) Date de publication et mention de la délivrance du brevet:
**28.01.2026 Bulletin 2026/05**

(21) Numéro de dépôt: **24159962.0**

(22) Date de dépôt: **27.02.2024**

(51) Classification Internationale des Brevets (IPC):
**G05D 1/243** (2024.01) **G05D 1/246** (2024.01)
**G05D 107/60** (2024.01) **G05D 109/10** (2024.01)

(52) Classification Coopérative des Brevets (CPC):
**G01R 33/02; G01V 3/08; G05D 1/243; G05D 1/246;**
G01C 21/08; G01R 33/10; G01V 3/40;
G05D 2107/60; G05D 2109/10

(54) **MÉTHODE DE DÉTERMINATION D'INFORMATIONS RELATIVES À UN CHANGEMENT DE REPÈRE ; PROGRAMME, SUPPORT D'INFORMATION ET SYSTÈME POUR LA MISE EN ŒUVRE DE LA MÉTHODE**

VERFAHREN ZUR BESTIMMUNG VON INFORMATIONEN BEZÜGLICH EINER LANDMARKENÄNDERUNG; PROGRAMM, INFORMATIONSTRÄGER UND SYSTEM ZUR DURCHFÜHRUNG DES VERFAHRENS

METHOD OF DETERMINING INFORMATION ABOUT A MARK CHANGE; PROGRAM, INFORMATION CARRIER AND SYSTEM FOR CARRYING OUT THE METHOD

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **28.02.2023 FR 2301864**

(43) Date de publication de la demande:
**18.09.2024 Bulletin 2024/38**

(73) Titulaire: **Commissariat à l'Energie Atomique et aux Energies Alternatives**
**75015 Paris (FR)**

(72) Inventeurs:
• **ABDUL RAOUF, Iad**
**91191 Gif Sur Yvette (FR)**
• **BOURGEOIS, Steve**
**91191 Gif Sur Yvette (FR)**
• **GAY-BELLILE, Vincent**
**91191 Gif Sur Yvette (FR)**
• **GUILLEMARD, Richard**
**91191 Gif Sur Yvette (FR)**
• **JOLY, Cyril**
**75272 Paris Cedex 06 (FR)**

(74) Mandataire: **Santarelli**
**Tour Trinity**
**1 bis Place de la Défense**
**92400 Courbevoie (FR)**

(56) Documents cités:
**JP-A- 2009 289 145    US-A1- 2016 084 659**
**US-B1- 8 781 739**

• **HAVERINEN J ET AL: "A global self-localization technique utilizing local anomalies of the ambient magnetic field", 2009 IEEE INTERNATIONAL CONFERENCE ON ROBOTICS AND AUTOMATION : (ICRA) ; KOBE, JAPAN, 12 - 17 MAY 2009, IEEE, PISCATAWAY, NJ, USA, 12 May 2009 (2009-05-12), pages 3142 - 3147, XP031510119, ISBN: 978-1-4244-2788-8**
• **SOLIN ARNO ET AL: "Terrain navigation in the magnetic landscape: Particle filtering for indoor positioning", 2016 EUROPEAN NAVIGATION CONFERENCE (ENC), IEEE, 30 May 2016 (2016-05-30), pages 1 - 9, XP032935316, DOI: 10.1109/EURONAV.2016.7530559**

**Description**

**DOMAINE TECHNIQUE DE L'INVENTION**

Le domaine de l'invention est celui des méthodes et systèmes permettant de déterminer la position et/ou l'orientation relative d'un système (robot, machine, objet connecté, etc.) par rapport à son environnement, en particulier à partir de mesures du champ magnétique. L'invention a des applications en particulier pour déterminer la position relative de systèmes à l'intérieur de bâtiments, et plus généralement en tout lieu où un positionnement par satellites (plus précisément, un positionnement GNSS, c'est-à-dire un positionnement par Géolocalisation et Navigation par un Système de Satellites) n'est pas disponible.

**ÉTAT DE LA TECHNIQUE**

Un grand nombre de méthodes ont été développées pour déterminer la position relative d'un système par rapport à son environnement. Parmi ces méthodes, les méthodes fondées sur l'exploitation de mesures du champ magnétique sont particulièrement intéressantes par le fait qu'elles nécessitent un capteur disponible et relativement bon marché, à savoir un magnétomètre, et surtout par le fait qu'elles peuvent être mises en œuvre en intérieur, lorsqu'un positionnement de type GNSS est peu ou pas envisageable. De manière générale, la détermination d'une position relative à partir du champ magnétique repose sur le constat que le champ magnétique varie spatialement dans le volume considéré, comme par exemple à l'intérieur d'un immeuble. Si la distribution du champ magnétique dans ce volume est connue, il est alors possible en théorie de déterminer la position relative d'un objet par rapport son environnement, en exploitant les informations disponibles quant à la distribution du champ magnétique.

Les documents cités dans la liste de références fournie ci-dessous divulguent différentes méthodes permettant de déterminer la position d'un repère fixe (appelé encore 'repère monde') associé à un système de mesure mobile par rapport à un deuxième repère monde dans lequel on dispose déjà d'un ensemble de mesures.

Cependant, ces méthodes présentent de multiples limitations ou inconvénients.

Une partie d'entre elles, par exemple le document Ref.1, suppose de connaître la position initiale du système de mesure par rapport à son environnement.

Une autre partie de ces méthodes par ailleurs ne permet de déterminer la position du système de mesure que s'il suit sensiblement la même trajectoire que celle (ou une de celles) suivie(s) par les systèmes de mesure qui ont réalisé les mesures initiales de l'environnement étudié.

Une partie de ces méthodes n'est pas exploitable à échelle réelle, dans un environnement ayant une certaine taille comme un bâtiment ayant plusieurs étages par exemple.

Il existe donc un besoin d'une méthode de détermination d'un changement de repère, permettant de déterminer le changement de repère entre un deuxième 'repère monde' associé à un système de mesure et un premier repère monde dans lequel on dispose déjà d'un ensemble de mesures précédemment déterminé, méthode qui puisse être mise en œuvre à l'aide de capteurs simples, en intérieur, qui soit robuste et soit susceptible de fournir en temps réel au moins une valeur approximative assez exacte du changement de repère cherché.

Références :

[1] J. Coulin, R. Guillemard, V. Gay-Bellile, C. Joly, and A. de L. Fortelle, "Tightly-Coupled Magneto-VisualInertial Fusion for Long Term Localization in Indoor Environment," IEEE Robot. Autom. Lett., vol. 7, no. 2, pp. 952-959, Apr.2022, doi:10.1109/LRA.2021.3136241

[2] A. Solin, S. Sarkka, J. Kannala, and E. Rahtu, "Terrain navigation in the magnetic landscape: Particle filtering for indoor positioning," in 2016 European Navigation Conference (ENC), Helsinki, Finland, May 2016, pp. 1-9. doi: 10.1109/EURONAV.2016.7530559.

[3] Documents de brevet JP5130419, US9683851

[4] H. Luo, F. Zhao, M. Jiang, H. Ma, and Y. Zhang, "Constructing an Indoor Floor Plan Using Crowdsourcing Based on Magnetic Fingerprinting," Sensors, vol. 17, no. 11, Art. no. 11, Nov. 2017, doi: 10.3390/s17112678.

[5] A. Basiri et al., "Indoor location based services challenges, requirements and usability of current solutions," Comput. Sci. Rev., vol. 24, pp. 1-12, May 2017, doi: 10.1016/j.cosrev.2017.03.002.

Des méthodes et systèmes permettant de déterminer la position et/ou l'orientation relative d'un système par rapport à son environnement sont par ailleurs divulgués par les documents US 8 781 739 B1, JP 2009 289145 A, US 2016/084659 A1.

## EXPOSÉ DE L'INVENTION

La présente invention vise à remédier à tout ou partie des inconvénients de l'état de la technique cités ci-dessus.

Dans ce but, suivant la présente divulgation la méthode suivante est proposée. Cette méthode est une méthode mise en œuvre par ordinateur de détermination d'au moins une information relative à un changement de repère global d'un deuxième repère associé à un deuxième ensemble de vecteurs comprenant de deuxièmes vecteurs vers un premier repère associé à un premier ensemble de vecteurs comprenant de premiers vecteurs, la méthode comprenant les étapes suivantes :

S10) on obtient lesdits premier et deuxième ensemble de vecteurs ;

chaque vecteur étant représentatif d'un champ magnétique dans le monde réel en une position exprimée dans le repère associé à l'ensemble de vecteurs, dite position de mesure ;
une première direction étant considérée comme commune au premier et au deuxième repère ;

S20) pour chaque deuxième vecteur, on identifie zéro, un ou une pluralité de premiers vecteurs, dit(s) premier(s) vecteur(s) associé(s), pour lequel ou lesquels une distance entre une représentation du deuxième vecteur et une représentation du premier vecteur considéré est inférieure à un seuil d'association ;

une représentation d'un vecteur étant une valeur obtenue en appliquant une fonction de représentation au vecteur considéré et/ou à la position de mesure associée au vecteur considéré,
la fonction de représentation étant telle que la représentation d'un vecteur est laissée invariante par l'application au vecteur et/ou à la position de mesure associée de toute transformation respectant un ensemble de contrainte ;
l'information à estimer relative au changement de repère global étant une information non fixée par la ou les contraintes de l'ensemble de contrainte ;
l'ensemble de contrainte inclut au moins la contrainte que la transformation conserve au moins la première direction invariante ;

S30) pour chaque association entre un premier vecteur et un deuxième vecteur, on détermine un changement de repère d'association respectant la ou les contraintes de l'ensemble de contrainte et optimisant une fonction d'optimisation fonction au moins :

- d'un écart d'alignement entre une direction (direction orientée) d'une transformée du deuxième vecteur par le changement de repère d'association et une direction (direction orientée) du premier vecteur associé ; et/ou
- d'un écart de position entre une transformée de la deuxième position de mesure attachée au deuxième vecteur par le changement de repère d'association et la première position de mesure attachée au premier vecteur associé,

S40) on identifie des groupements parmi les changements de repère d'association déterminés à l'étape S30 ;
S50) on détermine ladite au moins une information relative au changement de repère global en fonction du ou des groupements déterminés à l'étape S40.

Comme indiqué précédemment, cette méthode peut être mise en œuvre soit pour déterminer complètement le changement de repère global, soit pour déterminer seulement une partie des caractéristiques de celui-ci, comme par exemple une partie des composantes de translation, ou encore la composante de rotation autour de la première direction.

La mise en œuvre de la méthode nécessite de déterminer une ou plusieurs contraintes, dites contraintes de transformation, que le changement de repère global doit respecter. Ces contraintes consistent en général en le fait que certaines caractéristiques du changement de repère global sont prédéterminées ; par exemple certains des degrés de liberté du changement de repère global peuvent être fixés à des valeurs prédéterminées. Cette ou ces contraintes incluent au minimum, pour une transformation considérée, que la transformation conserve au moins la première direction invariante ; en d'autres termes, la transformation conserve au moins tout vecteur directeur orienté suivant la première direction invariant.

Ces contraintes de transformation peuvent aussi être plus restrictives.

Par exemple, dans certains modes de mise en œuvre les contraintes de transformation incluent en outre que la transformation soit la combinaison d'une translation de valeur prédéterminée suivant au moins une direction et/ou d'une rotation d'angle de rotation de valeur prédéterminée autour de la première direction.

La ou les caractéristiques du changement de repère que la présente méthode permet de déterminer est ou sont inversement une ou des caractéristiques (ou informations) non fixée(s) par ladite au moins une contrainte de transformation.

Chacun des premier et deuxième repère est un repère monde ('world frame' en Anglais) au sens utilisé généralement en robotique. Un repère monde peut être notamment un repère associé à un ensemble de mesures (ou de valeurs du champ magnétique), référencées par rapport à un point fixe dans le monde réel et avec une orientation fixe par rapport à ce point.

Avantageusement, la méthode ne nécessite, pour être mise en œuvre, que les données relatives aux deux ensembles de vecteurs (à savoir les valeurs de ceux-ci et leurs positions). Elle ne nécessite ni une connaissance d'une position initiale du système de mesure ou une valeur initiale du changement de repère global, ni d'autres données de mesure (résultats de mesures inertielles, GNSS, etc.). La méthode est mise en œuvre indépendamment de toute relation d'ordre ; elle n'impose pas que les vecteurs de l'un des ensembles de vecteurs aient été mesurés suivant une certaine trajectoire (par exemple, le long du même trajet) par rapport aux vecteurs de l'autre ensemble de vecteurs.

Néanmoins, la méthode nécessite qu'il y ait un certain recouvrement, c'est-à-dire une région commune, entre les positions de mesure des vecteurs du premier et du deuxième ensemble de vecteurs. Ce recouvrement doit naturellement être aussi grand que possible.

Par ailleurs, la méthode n'utilise pas d'approche probabiliste, et ne fait aucune référence à un pas de temps, une chronologie ou toute autre forme de référence au temps.

Dans la définition précédente, les repères associés respectivement au premier et au deuxième ensemble de vecteur sont des repères fixes, ou 'repères monde', définis par rapport au volume (au bâtiment, etc.) dans lequel se trouvent les positions de mesure de l'ensemble de vecteurs considéré.

Les vecteurs magnétiques (appelés aussi plus simplement 'vecteurs' par la suite) sont des vecteurs dont la valeur représente la norme et la direction (l'orientation) du champ magnétique au point de mesure.

Dans le présent document, une direction est définie par une droite associée à un sens le long de la droite.

Dans le présent document, les expressions 'changement de repère' et 'transformation' sont utilisées de manière interchangeable.

Les vecteurs magnétiques peuvent être exprimés, selon les modes de mise en œuvre, en deux ou trois dimensions (2D ou 3D). Ils peuvent être exprimés indifféremment en coordonnées cartésiennes, polaires ou autre.

Chacun des premier et deuxième ensemble de vecteurs peut être obtenu par toute méthode appropriée lors de l'étape S10 (extraction depuis une base de données, etc.).

Ces ensembles de vecteurs peuvent par exemple être obtenus en réalisant les étapes intermédiaires suivantes.

Dans une première étape S12, on acquiert le premier et le deuxième ensemble de vecteurs.

Chaque ensemble de vecteurs peut être obtenu soit lors d'une opération d'acquisition unique, soit de manière itérative au fur et à mesure que de nouvelles mesures sont disponibles.

Dans le premier cas, on obtient l'ensemble des valeurs de l'ensemble de vecteurs en une seule opération : par exemple, on réalise une campagne de mesure dans un bâtiment, et on acquiert en une opération l'ensemble de ces mesures pour alors mettre en œuvre la présente méthode.

Dans le deuxième cas, on met en œuvre par exemple la présente méthode de manière itérative. Dans ce cas, à l'étape S12 l'ensemble de vecteurs considéré peut être obtenu en ajoutant à l'ensemble de vecteurs obtenu lors d'une itération précédente de la méthode une ou plusieurs nouvelle(s) mesure(s) qui ont été réalisées depuis l'itération précédente et vont maintenant être prises en compte pour la nouvelle itération de la méthode.

Dans ce mode de mise en œuvre, il est aussi possible à l'étape S12 de supprimer de l'ensemble de vecteurs les valeurs les plus anciennes, afin que dans l'ensemble de vecteurs considéré le nombre de vecteurs conserve une valeur adaptée.

Dans les deux cas (mise en œuvre itérative ou non de la méthode), dans chacun des premier et deuxième ensemble de vecteurs les vecteurs magnétiques peuvent être acquis par des systèmes de mesure (tels que des magnétomètres), ou bien être calculés, par exemple à partir d'une simulation du champ magnétique dans le volume considéré (et/ou par exemple par interpolation à partir de valeurs mesurées).

Le premier et le deuxième repère présentent une direction commune dite première direction. Tout moyen peut être utilisé pour que dans les premier et deuxième ensembles de vecteurs, cette première direction soit convenablement prise en compte. Un accéléromètre peut par exemple être utilisé pour donner la direction verticale, etc.

Les positions de mesure par ailleurs peuvent être acquises en utilisant tout moyen approprié, comme par exemple une centrale inertielle, etc.

Dans certains modes de mise en œuvre, dès l'étape S12 les ensembles de vecteurs comportent une densité appropriée de vecteurs (en termes de nombre de positions de mesure par unité de surface ou de volume, dans le volume considéré). Par exemple, dans certains cas l'un et/ou l'autre des ensembles de vecteurs est généré par calcul, avec un pas déterminé entre les positions de mesure des différents vecteurs. Le plus souvent, un pas de discrétisation constant sur l'ensemble du volume considéré peut être utilisé pour les ensembles de vecteurs.

Cependant dans certains cas, un ensemble de vecteurs peut comporter des vecteurs ayant au moins dans certaines zones une densité de positions de mesure trop élevée.

Dans ce cas, il peut être souhaitable dans une étape S14 d'échantillonner l'ensemble de vecteurs considéré. Cette opération consiste à supprimer certains vecteurs, pour assurer que les vecteurs restants présentent des positions de mesure réparties de manière adaptée pour la mise en œuvre de la méthode. Il est notamment souhaitable lors de l'étape S14, si deux vecteurs ont des positions de mesure distantes de moins d'une certaine valeur seuil, de supprimer l'un des deux vecteurs concernés.

Enfin, dans certains modes de mise en œuvre le pas de discrétisation (la distance entre les positions de mesure de deux vecteurs ayant des positions de mesure voisines) peut être variable en fonction de la position dans le volume considéré.

Par exemple, le pas de discrétisation peut être plus faible dans les zones dans lesquelles les variations du champ magnétique (le gradient de champ magnétique) sont fortes. Le pas de discrétisation peut ainsi être choisi plus faible dans les pièces de petites dimensions que dans les grandes pièces. En effet en pratique, le champ magnétique varie davantage dans une petite pièce (telle qu'un couloir) que dans une grande pièce.

L'étape S20 de la méthode nécessite que l'on dispose de représentations.

Une représentation est une donnée, comme par exemple un vecteur, qui représente une valeur du champ magnétique à la position de mesure considérée.

La représentation d'un vecteur est de plus une donnée qui reste invariante, ou inchangée, lorsque l'on applique au vecteur et/ou à la position de mesure associée une quelconque transformation respectant la ou les contraintes de l'ensemble de contraintes, et que l'on recalcule alors la représentation, mais cette fois sur la base de la transformée du vecteur et/ou de sa position de mesure.

Par exemple, si l'on cherche à estimer l'orientation du champ magnétique, cette information doit être une information non fixée par la ou les contraintes de l'ensemble de contraintes ; en d'autres termes il doit donc y avoir des transformations qui respectent l'ensemble des contraintes de l'ensemble de contraintes mais qui font varier l'angle de rotation : c'est le cas de toutes les rotations d'axe orienté suivant la première direction.

Dans certains cas particuliers, la seule contrainte de transformation contenue dans l'ensemble de contrainte est le fait que la transformation conserve la première direction invariante. Il s'ensuit que l'ensemble des transformations qui respectent toutes les contraintes de transformation est la réunion de l'ensemble des rotations autour de la première direction et l'ensemble des translations et de leurs combinaisons.

La représentation d'un vecteur magnétique est donc dans ce cas une donnée représentant la valeur du champ magnétique à la position de mesure et qui est laissée invariante par l'application au vecteur et/ou à la position de mesure associée de toute rotation autour de la première direction.

La fonction de représentation est alors la fonction qui à un vecteur magnétique associe le couple comprenant comme première composante, la norme de la composante de ce vecteur dans un plan perpendiculaire à la première direction et comme deuxième composante, la composante de ce vecteur suivant la première direction.

Ainsi, dans certains modes de mise en œuvre, chaque représentation comprend, ou est constituée par, une composante représentative d'une norme d'une composante du champ magnétique dans un plan perpendiculaire à la première direction, une composante représentative d'une composante du champ magnétique suivant la première direction, et/ou une composante représentative d'au moins une coordonnée d'une position de mesure.

Par exemple si la première direction est la direction verticale, dans certains modes de mise en œuvre, chaque représentation inclut une composante représentative d'une composante horizontale du champ magnétique et/ou une composante représentative d'une composante verticale du champ magnétique.

Inversement, si la rotation pour passer du premier au deuxième repère est connue, les seules informations relatives au changement de repère global et que l'on peut vouloir déterminer sont celles relatives à translation.

Dans ce cas, la fonction de représentation peut être la fonction identité. Chaque représentation comprend, ou est constituée par le vecteur magnétique lui-même.

Dans d'autres modes de mise en œuvre encore, chaque représentation comprend, ou est constituée par, une composante représentative d'une norme du vecteur magnétique. Dans d'autres modes de mise en œuvre, l'ensemble de contrainte contient la contrainte que la transformation conserve au moins la première direction (la direction verticale) invariante ; mais de plus, les positions respectives selon les axes verticaux dans le premier et le deuxième repère sont considérées comme égales.

Dans ce cas on a donc trois degrés de liberté, à savoir deux en translation et un degré de liberté en rotation. Dans ce cas, la représentation peut être un vecteur dont la première composante est la norme de la composante du premier vecteur dans un plan perpendiculaire à la direction verticale, la deuxième composante est la composante du premier vecteur suivant la direction verticale, et la troisième composante est la composante suivant la direction verticale de la position de mesure. La représentation dans ce cas inclut donc une partie de la position de mesure.

L'étape S20 de recherche d'associations entre premiers et deuxièmes vecteurs est une étape importante de la méthode proposée.

Un premier vecteur et un deuxième vecteur ne peuvent être associés que si la distance entre la deuxième représentation (pour le deuxième vecteur) et la première représentation (pour le premier vecteur considéré) est inférieure au seuil d'association. Le seuil d'association peut être constant.

Néanmoins, dans certains modes de mise en œuvre, le seuil d'association est variable, et présente une valeur plus élevée dans des zones dans lesquelles une variation du champ magnétique est forte que dans des zones dans lesquelles une variation du champ magnétique est faible.

Cette façon de faire varier sélectivement la valeur du seuil d'association permet de déterminer les associations de manière plus efficace en limitant le nombre de faux positifs, c'est-à-dire d'associations injustifiées.

L'étape S20 peut être réalisée de manière à identifier, pour chaque deuxième vecteur, la totalité des associations entre le deuxième vecteur et le ou les premiers vecteurs pour lesquels la distance entre la deuxième représentation du deuxième vecteur et la première représentation du premier vecteur considéré est inférieure au seuil d'association.

Cependant, l'étape S20 peut être réalisée en n'identifiant qu'une partie de ces associations.

Par exemple, dans certains modes de mise en œuvre à l'étape S20, pour chaque deuxième vecteur, on identifie, en tant que premiers vecteurs associés, les premiers vecteurs qui sont tels que la première représentation et la deuxième représentation (pour les deux vecteurs considérés) satisfont un critère de proximité prédéterminé. Conformément à la présente divulgation, ce critère de proximité impose que la distance entre les représentations respectives de deux vecteurs identifiés comme associés soit inférieure au seuil d'association. Un exemple de critère de proximité sera donné par la suite.

Un tel critère de proximité peut être plus strict que la seule condition consistant à exiger que la distance entre les représentations respectives de deux vecteurs identifiés comme associés soit inférieure au seuil d'association.

Dans ce cas, la méthode selon la présente divulgation peut être mise en œuvre de telle sorte qu'à l'étape S20, pour un deuxième vecteur considéré, on ne retienne pas la totalité des premiers vecteurs pour lesquels la distance entre la représentation du deuxième vecteur et la représentation du premier vecteur est inférieure au seuil d'association : on limite la recherche de premiers vecteurs auxquelles le deuxième vecteur peut être associé à un sous-ensemble strict de l'ensemble des premiers vecteurs.

Cette restriction peut être réalisée notamment en prenant en compte des informations prédéterminées sur la position relative des représentations dans l'espace des représentations.

Dans ce but, dans certains modes de mise en œuvre, pour l'étape S20, les représentations du premier ensemble de vecteurs sont enregistrées dans une structure de données prenant en compte leurs positions dans l'espace des représentations, par exemple un arbre d'indexation, notamment un ball-tree, un quad-tree, ou un kd-tree et à l'étape S20, on identifie ledit ou lesdits premier(s) vecteur(s) associé(s) en parcourant ladite structure de données. Grâce à l'utilisation d'une structure de données telle qu'un arbre d'indexation qui prend en compte les positions respectives des représentations dans l'espace des représentations, la recherche de premiers vecteurs à associer au deuxième vecteur est effectuée seulement pour les premiers vecteurs dont les représentations sont voisines (ou proches) de la représentation associée au deuxième vecteur considéré.

De manière alternative, dans certains modes de mise en œuvre, l'étape S20 comprend les étapes suivantes :

S22) on détermine une partition en voxels de l'espace des représentations ; et
S24) quand les représentations d'un premier et d'un deuxième vecteur appartiennent au même voxel, on associe le premier vecteur et le deuxième vecteur.

Dans ces modes de mise en œuvre, de manière préférentielle l'étape S20 comporte en outre les étapes suivantes :

S25) pour au moins une partie des voxels, on identifie un ou des voxels adjacents ;
S26) quand les représentations d'un premier et d'un deuxième vecteur appartiennent à des voxels adjacents, on associe le premier vecteur et le deuxième vecteur.

Dans certains modes de mises en œuvre, le seuil d'association utilisé pour associer un premier vecteur à un deuxième vecteur considéré peut varier en fonction de l'importance des variations du champ magnétique dans le premier ensemble de vecteurs.

Par exemple, si dans une zone du volume considéré le champ magnétique varie relativement lentement (spatialement), alors une valeur faible pourra être choisie pour le seuil d'association, pour la zone considérée. En effet dans ce cas, deux vecteurs magnétiques de la zone considérée, bien qu'ayant des positions de mesure relativement éloignées dans le monde réel, peuvent tout de même avoir des représentations proches (du fait que le champ magnétique varie peu dans la zone considérée).

Dans ce cas, pour éviter d'associer les deux vecteurs magnétiques, ce qui serait inutile, on choisit un critère d'association plus sévère dans la zone considérée.

Aussi dans ce cas, comme cela a été expliqué précédemment on réduit donc la valeur du seuil d'association dans la zone considérée, en fonction de l'importance des variations du champ magnétique dans la zone considérée :

Le seuil d'association est donc choisi de manière à présenter une valeur plus forte dans les zones dans lesquelles une variation du champ magnétique est forte que dans les zones dans lesquelles une variation du champ magnétique est faible.

Cette manière de fixer les valeurs du seuil d'association peut être utilisée notamment lorsque l'espace des représentations est partitionné en voxels.

Dans ce cas, de préférence les dimensions des voxels sont choisies plus faibles dans les zones où le champ magnétique varie fortement (par unité de distance) que dans les zones dans lesquelles le champ magnétique varie faiblement (par unité de distance).

Par ailleurs, dans certains modes de mise en œuvre, à l'étape S20, pour chaque association entre un premier vecteur et un deuxième vecteur, on calcule en outre un coefficient de confiance dans l'association déterminée ; et à l'étape S40 on identifie les groupements en prenant en compte lesdits coefficients de confiance, et/ou à l'étape S50 on détermine au moins en partie le changement de repère global en prenant en compte lesdits coefficients de confiance.

Les différentes étapes du procédé de détermination d'informations suivant la présente divulgation peuvent être déterminées par des instructions de programmes d'ordinateurs. En conséquence, la présente divulgation vise aussi un programme d'ordinateur comprenant des instructions qui, lorsque les instructions sont exécutées par au moins un processeur, conduisent ledit au moins un processeur à exécuter les étapes de l'une des méthodes présentées précédemment.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

La présente divulgation vise aussi un support de stockage non-volatile lisible par ordinateur, sur lequel est stocké le programme d'ordinateur présenté précédemment. Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur. Alternativement, le support d'informations peut être un circuit intégré dans lequel le programme est incorporé, le circuit étant adapté pour exécuter ou pour être utilisé dans l'exécution du procédé en question.

Par extension, la présente divulgation vise aussi un système comprenant un magnétomètre, au moins un processeur, et un support d'informations tel que défini ci-dessus, ledit au moins un processeur étant configuré pour enregistrer des mesures de champ magnétiques effectuées par le magnétomètre sur ledit support d'informations. Un tel système peut être par exemple un véhicule, un robot, une machine, un système porté par un être humain (téléphone portable, casque, etc.), et plus généralement tout système dont il peut être utile de déterminer la position par rapport à son environnement.

## BRÈVE DESCRIPTION DES FIGURES

D'autres avantages, buts et caractéristiques particulières de la présente invention ressortiront de la description non limitative qui suit d'au moins un mode de réalisation particulier des dispositifs et procédés objets de la présente invention, en regard des dessins annexés, dans lesquels :

la [Fig. 1] est une vue du dessus schématique d'un bâtiment dans lequel évolue un robot, qui met en œuvre une méthode selon l'invention pour déterminer sa position ;

la [Fig. 2] est une vue du dessus schématique du robot qui apparaît sur la Fig.1 ;

la [Fig. 3] est une vue du dessus schématique d'une pièce du bâtiment de la Fig.1, montrant un ensemble de premiers vecteurs magnétiques et de premières positions correspondantes, dans la pièce du bâtiment représenté sur la Fig.1 ;

la [Fig. 4] est une vue du dessus schématique de la pièce représentée sur la Fig.3, montrant des mesures (deuxièmes vecteurs magnétiques et deuxièmes positions correspondantes) réalisées par le robot lors d'un déplacement dans cette pièce ;

la [Fig. 5] est une vue du dessus schématique montrant des associations identifiées entre un premier vecteur et de deuxièmes vecteurs ;

la [Fig. 6] est une vue du dessus schématique de la pièce représentée sur la Fig.3, montrant à la fois montrant l'ensemble des premiers vecteurs magnétiques et premières positions correspondantes représenté sur la Fig.3, et les deuxièmes vecteurs magnétiques et deuxièmes positions correspondantes, après recalage dans le repère du bâtiment ;

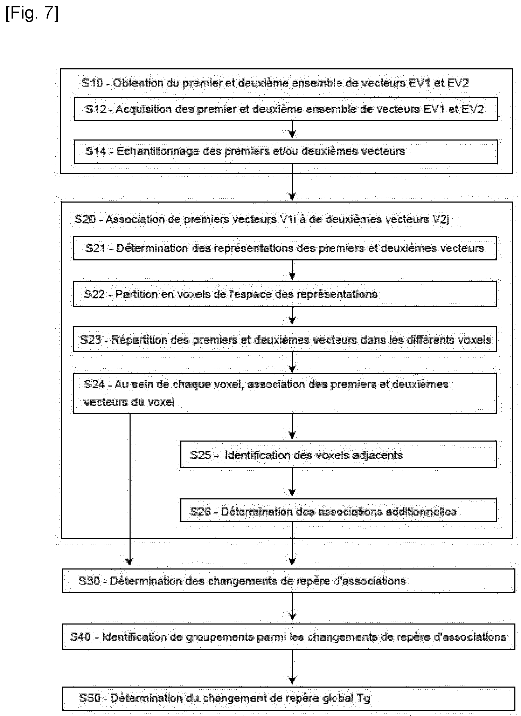

la [Fig. 7] est un logigramme montrant les étapes d'une méthode de détermination de changement de repère selon la présente divulgation ; et

la [Fig. 8] est une figure représentant de manière schématique des vecteurs magnétiques relevés dans un bâtiment.

## DESCRIPTION DÉTAILLÉE DE L'INVENTION

La présente description est donnée à titre d'exemple de réalisation non limitatif.

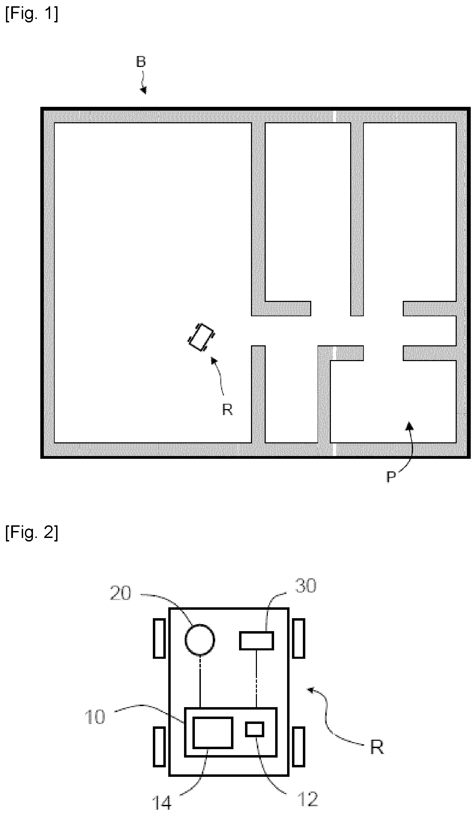

Les méthodes selon la présente divulgation vont être présentées dans le cas d'une mise en œuvre à bord d'un robot R évoluant à l'intérieur d'un bâtiment B (Fig.1).

Pour piloter le robot R lorsque celui-ci circule dans le bâtiment B il est nécessaire de connaître à chaque instant sa position, afin de contrôler ses accélérations et s'assurer qu'il suive la trajectoire voulue. Connaître la position du robot dans le bâtiment permet notamment de prendre en compte les informations dont on dispose à propos du bâtiment. Dans ce but, le robot R va mettre en œuvre une méthode suivant la présente divulgation pour connaître à chaque instant sa position relative, grâce au fait que la méthode permet de déterminer le changement de repère global Tg qui permet de transformer une position (en 3 ou 6 degrés de liberté) dans le repère R2 associé aux mesures effectuées par le robot, en une position dans le repère R1 du bâtiment B.

On suppose que l'on dispose d'une carte 3D du champ magnétique du bâtiment B, obtenue par exemple à partir de premières mesures réalisées précédemment dans le bâtiment. Cette carte 3D constitue un modèle continu du champ magnétique sur l'ensemble du bâtiment B (Les méthodes selon la présente divulgation étant cependant aussi applicables si les données de base sont discrètes).

Les vecteurs magnétiques fournis par la carte du champ magnétique en 3D, appelés 'premiers vecteurs', sont exprimés dans le repère R1 du bâtiment. Ce repère est orienté de telle sorte que l'une de ses directions (la 'première direction', ici notée z) soit orientée suivant la direction verticale. Ce résultat est obtenu simplement en prenant en compte le fait que le sol du bâtiment B est horizontal.

Le robot R est équipé d'un ordinateur de bord 10, d'un magnétomètre 20 et d'une centrale inertielle 30. L'ordinateur de bord 10 comporte un processeur 12 et une mémoire non volatile 14.

Le magnétomètre 20 est un magnétomètre calibré intégré au robot R.

L'ordinateur de bord 10 présente l'architecture matérielle d'un ordinateur, illustrée schématiquement sur la figure 2. De manière générale, tout dispositif de traitement de données comprenant au moins une mémoire apte à enregistrer des données et le programme qui va être présenté plus loin, et un ou plusieurs processeurs aptes à exécuter ce programme, peuvent être utilisé pour la mise en œuvre des méthodes suivant la présente divulgation.

Avec son magnétomètre 20, le robot R présenté ici constitue un exemple de dispositif suivant la présente divulgation. Dans le robot R l'ordinateur de bord 10 est embarqué à bord du robot. Dans les dispositifs selon la présente divulgation, le(s) processeur(s) et/ou la ou les mémoires néanmoins peuvent aussi être séparés du magnétomètre. Ils peuvent par exemple faire partie de serveurs distants.

La mémoire non-volatile 14 de l'ordinateur de bord 10 constitue un support d'enregistrement conforme à la présente divulgation, lisible par le processeur 12 et sur lequel est enregistré un programme d'ordinateur conforme à la présente divulgation, comportant des instructions pour l'exécution des étapes d'une méthode de détermination d'au moins une information relative à un changement de repère conforme à la présente divulgation.

La méthode utilisée pour calculer ladite au moins une information relative au changement de repère global permettant de transformer les positions de mesure exprimées dans le repère propre R2 du robot R en des positions dans le repère R1 du bâtiment B va maintenant être présentée.

Cette méthode comprend les étapes suivantes :

S10 - Obtention des premier et deuxième ensemble de vecteurs EV1 et EV2

S12 - Acquisition des ensembles de vecteurs

Le premier ensemble de vecteurs EV1 est généré à l'aide du modèle de champ magnétique du bâtiment décrit précédemment.

Il contient un ensemble de couples de la forme (V1i,P1i), i=1... N, où V1i est un premier vecteur, d'indice i, représentatif d'une valeur du champ magnétique en un point ; et P1i est ce point, également appelé 'position de mesure' (même si la valeur du vecteur V1i ne provient pas d'une mesure, mais est par exemple calculée, ou estimée à partir d'autres grandeurs). Les coordonnées de P1i sont exprimées dans le repère R1.

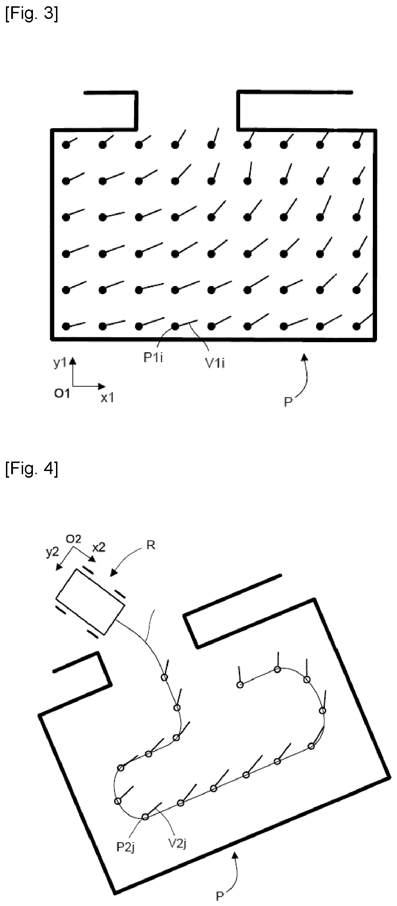

La répartition des vecteurs magnétiques V1i à des positions P1i est illustrée sur la Fig.3 pour l'une des pièces du bâtiment B (la pièce P). Sur cette figure, les normes et orientations des premiers vecteurs magnétiques V1i sont arbitraires.

Les données du premier ensemble EV1 peuvent être générées à des positions de mesure P1i régulièrement ou à peu près régulièrement échelonnées suivant les deux directions horizontales x et y (Fig.3), avec un pas de discrétisation sensiblement égal dans les deux directions. Dans d'autres modes de mise en œuvre prenant davantage en compte la direction verticale, les positions de mesure P1i peuvent être échelonnées suivant les trois directions x, y et z.

On acquiert ensuite le deuxième ensemble de vecteurs EV2 à l'aide du robot R. Le robot R circule dans le bâtiment B en acquérant successivement un certain nombre de mesures V2j du champ magnétique (j=1....M) à des positions de mesure successives P2j, comme représenté sur la Fig.4.

S14 - Discrétisation des ensembles de vecteurs

Ensuite dans l'étape S14, s'il y a lieu, on discrétise spatialement le premier ensemble de vecteurs EV1 et/ou le deuxième ensemble de vecteurs EB2.

En effet il est inutile qu'un ensemble de vecteurs contienne deux vecteurs ayant des positions de mesure trop proches l'une de l'autre.

Ainsi, il peut être utile d'échantillonner l'un et/ou l'autre des ensembles de vecteurs dès qu'il est susceptible de contenir des couples de vecteurs ayant des positions de mesure trop proches l'une de l'autre. Par 'échantillonner', on désigne ici une opération de suppression de données (de couples (vecteur, position de mesure)) de l'ensemble de vecteurs de manière à assurer que pour tout couple de vecteurs de l'ensemble de vecteurs, la distance entre les positions de mesure associées est supérieure à une certaine valeur minimale prédéterminée.

Dans certains modes de réalisation, l'échantillonnage peut être fait spécifiquement dans certaines parties du volume étudié.

En effet, pour augmenter la précision de la méthode, il est avantageux de faire varier le pas d'échantillonnage en fonction de la position dans le volume étudié, et par exemple d'avoir un pas de discrétisation plus faible dans les zones dans lesquelles les variations du champ magnétique sont plus rapides. Le pas de discrétisation peut par exemple être choisi plus faible dans les couloirs que dans les grandes pièces.

S20 - Détermination des associations entre premiers et deuxièmes vecteurs

On associe alors chaque deuxième vecteur magnétique (V2j) du deuxième ensemble de vecteurs EV2 avec, lorsque c'est possible, un ou plusieurs premiers vecteurs magnétiques V1i avec lequel ou lesquels un critère de proximité entre leurs représentations respectives R1i et R2j est satisfait.

Il peut arriver, en fonction des paramètres de mise en œuvre, qu'une partie des deuxièmes vecteurs ne soient associée à aucun premier vecteur. Un deuxième vecteur V2j est associé à un premier vecteur V1i lorsque les deux représentations R1i et R2j de ces deux vecteurs sont suffisamment proches, c'est-à-dire lorsque la distance entre celles-ci dans l'espace des représentations est inférieure au seuil d'association.

Cette valeur est choisie de manière heuristique, en prenant en compte notamment le bruit de mesure du magnétomètre, de telle sorte que dans la mesure du possible, deux vecteurs représentant des mesures du champ magnétique effectuées à des positions voisines soient associés. Par 'positions voisines', on désigne ici notamment deux positions séparées d'une distance nettement plus faible que le pas de discrétisation avec lequel le premier ensemble de vecteurs EV1 est constitué.

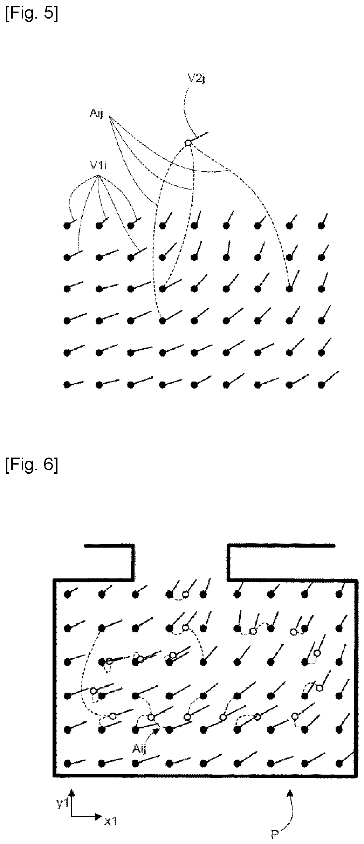

Une représentation schématique de certaines associations possibles Aij entre un deuxième vecteur V2j et de premiers vecteurs V1i, représentées par des traits en pointillés, sont indiquées sur la Fig.5.

S21 - Détermination des représentations des premiers et deuxièmes vecteurs

Pour déterminer les associations entre premiers et deuxièmes vecteurs, la première étape S21 consiste à calculer les représentations des premiers et deuxièmes vecteurs V1i et V2j.

Dans le mode de mise en œuvre présenté ici, l'ensemble de contrainte inclut comme seule contrainte le fait que la transformation conserve la première direction verticale invariante. La représentation R1i d'un vecteur magnétique V1i est le couple $(|V1ixy|, V1iz)$, où $|V1ixy|$ et $V1iz$ représentent respectivement la norme de la composante horizontale, et la composante verticale, du vecteur magnétique V1i. De même, avec des notations analogues, la représentation R2j d'un vecteur magnétique V2j est le couple $(V2jxy, V2jz)$. Ce choix de composantes permet que les représentations R1i et R2j soient indépendantes de la rotation autour de l'axe vertical Z, qui est une des informations que l'on cherche à déterminer.

Ensuite, différentes étapes peuvent être suivies pour finaliser le choix des associations entre premiers et deuxièmes vecteurs. Trois différentes variantes vont maintenant être présentées.

Selon une première variante, pour chaque deuxième vecteur, on évalue pour chacun des premiers vecteurs, s'il peut être associé au deuxième vecteur considéré, c'est-à-dire s'il satisfait le critère de proximité choisi.

Cette variante est simple, mais peut être relativement coûteuse en temps de calcul. En effet le nombre d'associations possibles à évaluer peut alors être très élevé.

Pour réduire le temps de calcul, il est préférable de limiter autant que possible le nombre d'associations évaluées lors de l'étape S20.

Pour cette raison, dans les deuxièmes et troisième variante au contraire, pour chaque deuxième vecteur, on évalue les premiers vecteurs susceptibles d'être associés au deuxième vecteur considéré seulement pour un sous-ensemble strict du premier ensemble de vecteurs.

Dans la deuxième variante, le critère de proximité entre les représentations du premier et du deuxième vecteur est simplement un critère de distance entre représentations : la distance entre la représentation du premier vecteur et celle du deuxième vecteur doit être inférieure au seuil d'association qui représente ainsi un 'écart maximal accepté'.

La deuxième variante comporte une première étape S21, dans laquelle on enregistre le premier ensemble de vecteurs sous forme d'arbre d'indexation.

Tout type d'arbre d'indexation de données qui permet d'enregistrer les premiers vecteurs en fonction des positions de leurs représentations respectives dans l'espace des représentations peut être utilisé. On peut par exemple utiliser un kd-tree, un quadtree, etc.

Avantageusement, un tel arbre peut être parcouru de manière optimisée ; la recherche du ou des premiers vecteurs ayant des représentations proches de la représentation d'un deuxième vecteur considéré se fait de manière optimisée sans qu'il soit nécessaire d'évaluer si le critère de proximité est satisfait pour chacun des vecteurs du premier ensemble de vecteurs.

Dans la deuxième étape S22 de la variante, pour chaque vecteur du deuxième ensemble de vecteurs on parcourt l'arbre d'indexation de manière à identifier le ou les premiers vecteurs dont les représentations satisfont le critère de proximité par rapport à la représentation du deuxième vecteur considéré, c'est-à-dire, de manière à identifier le ou les premiers vecteurs dont les représentations sont à une distance inférieure à l'écart maximal accepté (le seuil d'association) par rapport à la représentation du deuxième vecteur considéré.

Pour chaque deuxième vecteur, le ou les premiers vecteurs ainsi identifié est alors associé au deuxième vecteur considéré.

Dans la troisième variante, le critère de proximité entre un premier et un deuxième vecteur est défini à partir de voxels, qui sont définis dans l'espace des représentations. La troisième variante inclut les étapes S22 à S24 ci-dessous :

S22 - Partition de l'espace des représentations en voxels

La troisième variante nécessite dans une première étape S22 de partitionner l'espace des représentations en voxels (c'est-à-dire en volumes élémentaires). Chaque voxel a un volume fini.

Grâce à cette partition, le critère de proximité peut être défini simplement, de la manière suivante : un premier et un deuxième vecteur satisfont le critère de proximité lorsque les représentations de ces deux vecteurs font partie du même voxel.

S23 - Répartition des premiers et deuxièmes vecteurs dans les différents voxels

A l'étape S23, on affecte chacun des premiers et deuxièmes vecteurs au voxel qui contient sa représentation.

Dans certains modes de mise en œuvre, on procède alors directement à l'étape S26 : S24 - Au sein de chaque voxel, association des premiers et deuxièmes vecteurs du voxel A l'étape S24, pour chacun des voxels, on associe chacun des premiers vecteurs affectés au voxel avec chacun des deuxièmes vecteurs affectés au même voxel.

Comme chacun des voxels a un volume fini, pour chaque paire de vecteurs associés, l'appartenance du premier et du deuxième vecteur de la paire de vecteurs au même voxel impose donc une valeur maximale à la distance entre les représentations respectives de ces deux vecteurs.

Cependant, certains modes de mise en œuvre de la troisième variante sont optimisés afin de réduire les effets de bord, ou de limite, dus aux voxels et comportent dans ce cas deux étapes additionnelles S25 et S26.

S25 - Identification des voxels adjacents

A l'étape S25, pour chaque voxel, on identifie les voxels adjacents au voxel considéré, dans l'ensemble des représentations.

S26 - Pour chaque voxel, détermination des associations additionnelles

Ensuite dans une étape S26, on ajoute les associations suivantes aux associations entre premiers et deuxièmes vecteurs déjà identifiées à l'étape S24 :
Pour chaque voxel, on associe chaque deuxième vecteur contenu dans le voxel considéré à chaque premier vecteur de chaque voxel adjacent au voxel considéré.

S30 - Pour chaque association, détermination du changement de repère d'association Tij

Une fois les associations entre premiers et deuxièmes vecteurs identifiées (à l'étape S20), à l'étape S30, pour chaque association Aij, on détermine le changement de repère d'association Tij. Ce changement de repère Tij tend, pour l'association considérée, à transformer le deuxième vecteur V2j en le premier vecteur associé V1i et la deuxième position de mesure P2j attachée au deuxième vecteur V2j en la première position de mesure P1i du premier vecteur V1i associé.

Plus précisément, le changement de repère d'association Tij est calculé de manière, tout en respectant la ou les contraintes de l'ensemble de contrainte, à optimiser la fonction d'optimisation. Cette fonction est fonction au moins :

- d'un écart d'alignement entre la direction de la transformée Tij(V2j) du deuxième vecteur V2j par le changement de repère d'association Tij et une direction du premier vecteur associé V1i ; et/ou

- d'un écart de position entre la transformée Tij(P2j) de la deuxième position de mesure P2j attachée au deuxième vecteur V2j et la première position de mesure P1i attachée au premier vecteur associé V1i.

La fonction d'optimisation vise normalement à minimiser à la fois l'écart d'alignement et l'écart de position mentionnés ci-dessus.

La fonction d'optimisation peut par exemple être une fonction visant à minimiser une somme pondérée, par des coefficients respectifs, de l'écart d'alignement et l'écart de position.

On peut procéder de différentes manières pour déterminer un changement de repère d'association Tij. On peut par exemple réaliser les opérations suivantes :

- On identifie l'ensemble Eij_opt des transformations optimales qui optimisent la fonction d'optimisation parmi toutes les transformations possibles, sans tenir compte de l'ensemble de contraintes.
- On identifie par ailleurs l'ensemble des transformations Tij admissibles, qui sont les changements de repère qui respectent l'ensemble des contraintes.
- On identifie alors la transformation Tij comme étant la transformation de l'ensemble des transformations Tij admissibles qui est la plus proche de l'ensemble Eij_opt des transformations optimales (au sens d'une distance dans l'espace des changements de repère).

Un exemple concret de calcul d'un changement de repère d'association Tij va maintenant être présenté.

Dans cet exemple, le premier et le deuxième ensemble de vecteurs EV1 et EV2 présentent une première direction commune qui est la direction verticale z. L'ensemble de contrainte inclut comme seule contrainte le fait que la transformation conserve la première direction verticale invariante. Par conséquent, chaque changement de repère Tij comporte seulement 4 degrés de libertés, à savoir trois degrés de liberté en translation et un degré de liberté concernant l'angle de rotation autour de la direction verticale. Le changement de repère individuel Tij est donc la combinaison d'une translation tij et d'une rotation rij.

Pour calculer le changement de repère d'association Tij, on procède aux étapes suivantes :
On définit tout d'abord l'azimuth A1i associé à un vecteur magnétique V1i comme étant l'angle de rotation permettant d'aligner la composante horizontale de ce vecteur avec l'axe Ox du repère R1. On a alors :

$$A1i = \text{arctan2}(V1i\_y, V1i\_x)$$

où V1i_x et V1i_y sont les composantes du vecteur V1i respectivement suivant les axes x et y, et la fonction arctan2 est la fonction arc tangente généralisée, connue en soi.

On définit de même l'azimuth A2j du vecteur magnétique V2j dans le repère R2.

A partir de l'azimuth A1i, on définit une matrice de rotation R1i autour de l'axe z (de la première direction). Cette matrice R1i peut être notamment de la forme :

$$R1i = \begin{pmatrix} \cos(A1i) & -sin(A1i) & 0 \\ sin(A1i) & cos(A1i) & 0 \\ 0 & 0 & 1 \end{pmatrix}$$

On combine alors le vecteur position P1i du vecteur magnétique avec la matrice rotation R1i de manière à former une matrice bloc de transformation rigide T1i, de taille 4x4.

On constitue de la même manière une matrice de transformation rigide T2j.

On calcule alors le changement de repère d'association Tij pour le deuxième vecteur V2j et le premier vecteur V1i simplement par composition des transformations rigides T1i et T2j :

$$Tij = T1i * T2j^{-1}$$

Le calcul des changements de repère d'association peut prendre d'autres formes en fonction des contraintes prises en compte dans l'ensemble de contrainte.

Dans un premier cas particulièrement simple, dans l'ensemble de contrainte on a attribué par avance des valeurs déterminées aux trois angles de rotation du changement de repère global. De ce changement de repère global, il ne reste donc qu'à estimer (au plus) les 3 degrés de liberté en translation. Dans ce cas spécifique la translation t_ij pour passer du deuxième repère R2 au premier repère R1 se calcule simplement, et vaut :

$$t\_ij = P2j – P1i$$

Dans un deuxième cas, l'ensemble de contrainte contient la contrainte que la transformation conserve au moins la première direction (direction verticale) invariante ; mais de plus, les positions respectives selon les axes verticaux dans le premier et le deuxième repère sont considérées comme égales.

Dans ce deuxième cas, le changement de repère d'association Tij se calcule sensiblement de la même manière que dans l'exemple concret présenté ci-dessus, dans lequel la seule contrainte de l'ensemble de contrainte est le fait que la transformation conserve la première direction verticale invariante.

Cependant, dans ce deuxième cas, pour former la matrice bloc de transformation rigide T1i, de taille 4x4, on combine alors un vecteur comprenant les deux composantes suivant les axes x et y du vecteur position P1i et ayant comme troisième composante la valeur 0 (pour la composante suivant l'axe z) avec la matrice rotation R1i.

On constitue de la même manière la matrice de transformation rigide T2j.

On calcule alors le changement de repère d'association Tij de la même manière que dans l'exemple concret présenté ci-dessus.

S40 - Identification de groupements parmi les changements de repère d'associations

Une fois les changements de repère d'association déterminés à l'étape S30, on regroupe alors ces changements de repère en un ou plusieurs groupements (en Anglais, 'clusters').

Cette opération est conduite sur la base de l'ensemble des changements de repère d'associations déterminés à l'étape S30.

Un groupement, ou 'cluster', est un sous-ensemble de l'ensemble des changements de repère obtenus à l'étape S30.

A l'étape S40, les éléments d'un tel groupement sont identifiés ou sélectionnés selon au moins un critère de groupement.

Le critère de groupement est fondé sur au moins un critère de proximité, fonction de l'information contenue dans les changements de repères. Ce critère de proximité peut par exemple être défini à partir d'une fonction distance dans l'espace mathématique SE(3) des changements de repère. Il peut aussi être défini à partir d'une distance ou d'une combinaison de distances calculée(s) en fonction d'une partie du changement de repère, comme la translation uniquement, ou la rotation uniquement.

En plus du critère de proximité, un ou plusieurs autres critères, tels qu'un critère de densité et/ou de confiance, peuvent être utilisés pour définir le critère de groupement servant à identifier les groupements.

Par exemple, un algorithme utilisant uniquement un critère de proximité spatiale (comme critère de groupement) peut permettre de constituer (ou identifier) un groupement en incluant de proche en proche des changements de repères non encore inclus dans le groupement, mais situés dans au moins un voisinage V de rayon prédéfini, centré sur un changement de repère déjà intégré au groupement en cours d'identification.

Le critère de groupement peut aussi prendre en compte un critère de densité. Par exemple, un changement de repère non déjà inclus à un groupement en cours d'identification peut être ajouté à celui-ci seulement si au moins un voisinage V (tel que défini précédemment) a une densité d'éléments suffisamment élevée, c'est-à-dire si le nombre de changements de repère qu'il contient divisé par le volume du voisinage V dépasse un certain seuil prédéterminé. Cette méthode d'identification de groupements s'appelle DBSCAN (voir publication correspondante ci-dessous).

Plus généralement, au lieu de n'inclure un changement de repère à un groupement que si un seuil minimal fonction de la densité du voisinage V est atteint, on peut choisir d'inclure un changement de repère à un groupement en cours d'identification seulement si un certain 'score de voisinage' pour le voisinage V dépasse une valeur seuil prédéterminée. Ce score de voisinage peut par exemple être fixé comme étant égal à la somme des scores de chaque changement de repère que le voisinage contient. Ces scores 'individuels' de changement de repère peuvent être calculés de différentes manières. Par exemple, dans certains modes de mise en œuvre ces scores 'individuels' de changement de repère représentent un degré de confiance déterminée à l'étape S30 pour le changement de repère considéré. Ce degré de confiance peut être défini à partir de l'incertitude sur les vecteurs magnétiques et/ou de leurs positions et orientation, qui ont servi à calculer le changement de repère.

L'identification des groupements à l'étape S40 peut aussi se faire de manière itérative ; par exemple, on peut identifier un premier ensemble de groupements, d'ordre 1, à l'aide d'un premier critère, puis on identifie de manière plus fine de nouveaux groupements, d'ordre 2, à l'aide d'un autre critère, et ainsi de suite.

Ainsi, l'étape S40 peut être réalisée par toute méthode d'identification de groupement ('clustering') connue, par exemple DBSCAN ou GDBSCAN ; ces algorithmes sont divulgués notamment par les documents :

- M. Ester, H.-P. Kriegel, J. Sander, and X. Xu, "A Density-Based Algorithm for Discovering Clusters in Large Spatial Databases with Noise," in Proceedings of the 2nd ACM International Conference on Knowledge Discovery and Data Mining, 1996, pp. 226-231 ; et «
- Sander, Jörg, et al. « Density-based clustering in spatial databases : The algorithm gdbscan and its applications. » Data mining and knowledge discovery 2 (1998) : 169-194.)
- R. Brégier, F. Devernay, L. Leyrit, and J. L. Crowley, "Defining the Pose of Any 3D Rigid Object and an Associated Distance," International Journal of Computer Vision, vol. 126, no. 6, pp. 571-596, Jun. 2018
- E. Schubert, J. Sander, M. Ester, H. P. Kriegel, and X. Xu, "DBSCAN Revisited, Revisited: Why and How You Should (Still) Use DBSCAN," ACM Transactions on Database Systems, vol.42, no. 3, Aug. 2017.

Une présentation des principaux algorithmes de clustering est également disponible sur la page https:// scikit-learn.org/stable/modules/clustering.html.

L'étape S40 permet d'identifier de manière relativement rapide les changements de repère d'association qu'il convient de prendre en compte pour la détermination du changement de repère global (ou d'informations relatives à celui-ci), en éliminant inversement de nombreuses associations et leurs changements de repère associés qui sont de 'faux positifs' qui ne correspondent pas du tout au changement de repère global.

Lors de l'étape S40, en général une grande partie des associations sont identifiées comme étant des faux positifs, ne générant pas un changement de repère pouvant être considéré comme correspondant au changement de repère entre les repères R1 et R2.

De plus, si plusieurs groupements sont identifiés, on détermine la différence entre le nombre N1 d'éléments du groupement le plus important par rapport au nombre d'éléments N2 du deuxième groupement le plus important. Si cet écart ne semble pas suffisant (par exemple si N1 n'est pas au moins égal à 1,5 x N2), on considère que le résultat est ambigu et la méthode est interrompue.

Pour réaliser cette étape S40, il est nécessaire de disposer d'une distance dans l'espace des changements de repère. De manière générale, toute distance appropriée peut être utilisée. On peut par exemple utilisée l'une des distances habituellement utilisées dans le domaine de la robotique pour mesurer une distance entre deux poses d'un corps solide dans l'espace.

Ainsi par exemple, dans le mode de mise en œuvre présenté ici, un changement de repère est représenté par un vecteur ayant quatre composantes $(x, y, z, \psi)$, où est $\psi$ l'angle de la rotation permettant de passer du deuxième repère R2 au premier repère R1. Il convient naturellement de tenir compte de la périodicité de l'angle $\psi$.

La distance suivante peut par exemple être utilisée :

$$d\left(T_1, T_2\right) = \sqrt{\alpha \left\| \log\left(R_1^{-1} R_2\right) \right\|^2 + \beta \left\| t_2 - t_1 \right\|^2}$$

Dans cette expression, $\alpha$ et $\beta$ sont des coefficients réels strictement positifs qui permettent de prendre en compte la différence d'échelle entre les valeurs liées à la rotation (R). La fonction log désigne ici la fonction permettant de passer d'une matrice de rotation 3x3 à sa représentation sous la forme d'un vecteur de rotation, la direction du vecteur représentant l'axe de rotation et la norme représentant l'angle de rotation.

S50 - Détermination du changement de repère global Tg à partir des groupements de changements de repère

Enfin dans l'étape S50, on détermine alors la ou les informations cherchées relatives au changement de repère global Tg entre le premier et le deuxième repère.

Dans la description qui suit, pour simplifier, on se place dans le cas où les informations que l'on cherche à déterminer sont le changement de repère global Tg lui-même, c'est-à-dire, les trois composantes de translation et la composante de rotation autour de la direction verticale. Néanmoins, les méthodes selon la présente divulgation peuvent être utilisées pour déterminer seulement d'une partie des informations définissant ce changement de repère global.

Toute méthode appropriée peut être utilisée pour déterminer le changement de repère global Tg en fonction du ou des groupements déterminés à l'étape S40.

Le changement de repère global Tg peut notamment être déterminé en fonction de l'importance des groupements.

Le changement de repère global Tg peut ainsi notamment être déterminé en fonction seulement du groupement le plus important.

Le changement de repère global Tg peut également être déterminé en fonction d'une pluralité de groupements considérés comme étant les plus importants : seuls ces groupements seront alors pris en compte pour le calcul du changement de repère global Tg. On peut dans ce cas par exemple calculer pour chacun des groupements les plus importants un changement de repère global. On peut alors par exemple, à partir de ceux-ci, déterminer le changement de repère global Tg, par une méthode de pondération appropriée.

Pour sélectionner le ou les groupements considérés comme étant les plus importants, si les groupements ont été identifiés à l'étape S40 en utilisant un critère de groupement fondé sur la densité, alors, on peut déterminer le ou les groupement(s) considéré(s) comme le(s) plus important(s) de la manière suivante : on sélectionne un ou plusieurs groupements comme étant 'le(s) plus important(s)' en fonction d'un critère de sélection fondé sur la somme d'un critère de confiance des changements de repère qui le composent. Le ou les groupements ayant les scores les plus élevés sont ainsi sélectionnés.

Le changement de repère global peut être calculé ou déterminé à partir des changements de repère du ou des groupements le(s) plus important(s), de différentes manières.

Le changement de repère global peut être par exemple calculé comme étant égal à la moyenne des changements de repère contenus dans le(s) groupement(s) le plus important(s).

Selon certaines variante, le changement de repère global peut par exemple être calculé à partir seulement d'un sous ensemble des changements de repère contenus dans le(s) groupement(s) le(s) plus important(s). En effet, une partie (ou un sous-ensemble) des éléments de ce groupement peut être extraite de ce groupement, en utilisant par exemple un critère de confiance.

Dans certaines de ces variantes, le changement de repère global peut par exemple être calculé comme étant égal la moyenne des changements de repère de la partie du/des groupement(s) le(s) plus important(s) qui a été extraite.

De plus, plutôt que de calculer une moyenne, le changement de repère global Tg peut être choisi comme étant égal à l'un des changements de repère du/des groupement(s) le(s) plus important(s). Par exemple le changement de repère global Tg peut être choisi comme étant le changement de repère autour duquel la densité est la plus élevée, au sein de ce(s) groupement(s).

Le changement de repère global Tg peut aussi être choisi comme étant le changement de repère du groument le plus important pour lequel la somme des distances aux autres changement de repère de ce groupement est minimale.

En outre, on peut sélectionner le changement de repère global Tg en prenant en compte d'autres critères, notamment en prenant en considération d'autres connaissances que l'on possède sur le changement de repère global. Par exemple, si on dispose d'une connaissance approximative a priori de la valeur du changement de repère global, alors on peut choisir de sélectionner le changement de repère du groupement le plus important qui se rapproche le plus de cette valeur.

Lorsque le changement de repère est calculé par une fonction de moyenne appliquée à un ensemble de changements de repère, toute fonction permettant d'obtenir une valeur moyenne des changements de repère de l'ensemble de changements de repère considéré peut être utilisée.

Ainsi, dans le cas où le changement de repère global Tg cherché inclut la rotation autour de la première direction, l'angle de rotation $\psi$ du changement de repère global peut par exemple être calculé de la manière suivante.

On considère l'ensemble des angles de rotation des vecteurs du groupement le plus important. On calcule la moyenne C des cosinus de ces angles et la moyenne S des sinus de ces angles.

On calcule alors l'angle de rotation $\psi$ du changement de repère global comme étant un angle moyen par la fonction arctangente généralisée Arctan2, suivant la formule :

$$\psi = \text{Arctan2}(S,C)$$

Le changement de repère Tg calculé à l'étape S50 peut s'il y a lieu être vérifié de différentes manières. On peut notamment appliquer ce changement de repère aux positions de mesure P2j et aux vecteurs magnétiques V2j de manière à obtenir leurs transformées dans le repère R1. Si ces transformées ne correspondent aux vecteurs et aux positions V1i environnants, on peut en conclure que le changement de repère Tg déterminé à l'étape S50 est incorrect.

Cette vérification est illustrée par la figure 6, qui montre de manière schématique les deuxièmes vecteurs V2j, dans la position qu'ils occupent lorsque le changement de repère Tg leur a été appliqué : Les vecteurs V2j sont alors positionnés à des positions Tg(P2j). Comme le montre la figure 6, les valeurs des vecteurs V2j ainsi recalées dans le repère R1 sont voisines avec des valeurs V1i des premiers vecteurs autour des vecteurs V2j recalés dans le repère R1.

Dans certains modes de mise en œuvre, le calcul du changement de repère global Tg est pondéré en fonction de la confiance que l'on a dans les différentes associations entre premiers et deuxièmes vecteurs identifiées.

Dans ce cas, la méthode peut par exemple comporter les opérations suivantes :
A l'étape S20, pour chaque association Aij entre un premier vecteur V1i et un deuxième vecteur V2j, on calcule en outre un coefficient de confiance Cij représentatif de la confiance que l'on a en l'association ij ; et à l'étape S40 on identifie les groupements en prenant en compte lesdits coefficients de confiance, et/ou à l'étape S50 on détermine le changement de repère global Tg en prenant en compte lesdits coefficients de confiance Cij.

On peut par exemple, à l'étape S40 et/ou S50, ne pas prendre en considération les associations dont l'indice de confiance est inférieur à un certain seuil.

Résultats

La méthode de détermination de changement de repère selon la présente divulgation a été testée dans un bâtiment s'étendant sur deux niveaux.

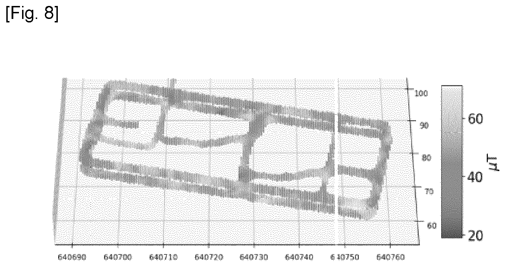

Une carte magnétique du bâtiment a tout d'abord été établie et a permis d'obtenir un premier ensemble de vecteurs EV1. Les vecteurs magnétiques ainsi obtenus sont schématiquement représentés sur la Fig.8. La palette de couleur en niveaux de gris représente la norme du champ magnétique, dont les valeurs sont comprises entre 18 et 78 $\mu$T.

Ensuite, la méthode selon la présente divulgation a été testée au cours de 51 expériences successives.

Pour cela, 51 relevés magnétiques différents ont été effectués dans le bâtiment et ont fourni successivement 51 deuxièmes ensembles de vecteurs EV2.

Les vecteurs magnétiques des premier et deuxième ensembles de vecteurs EV1 et EV2 ont été discrétisés avec un pas de 0,5 m.

Sur la base du premier ensemble de vecteur EV1 et des deuxièmes ensembles de vecteurs EV2 successivement obtenus, les étapes S20 à S50 de la méthode selon la présente divulgation ont alors été réalisées.

Pour la réalisation de l'étape S20, le premier ensemble de vecteurs a été organisé sous forme de kd-tree. Lors de chaque expérience, la recherche de couples de vecteurs associés a alors permis d'identifier plusieurs milliers d'associations.

Pour chaque expérience, les résultats suivants ont pu être obtenus :
A l'étape S30, pour chaque association le changement de repère d'association correspondant a été calculé.

L'étape S40 de recherche de groupements a alors fait apparaître qu'une très grande majorité (5956) de ces associations fournit un changement de repère d'association isolé ou sensiblement isolé, constituant donc un faux positif ne pouvant correspondre au changement de repère global Tg cherché. Inversement l'étape S40 a fait apparaître cinq groupements de changements de repère (totalisant 84 changements de repère d'associations), le groupement le plus important de ceux-ci regroupant 45 changements de repère d'associations.

Le changement de repère global Tg a alors pu être calculé à partir des changements de repère d'associations du groupement le plus important.

Comme cela a été indiqué, 51 expériences sensiblement identiques ont été effectuées. Chaque expérience a été conduite en utilisant un deuxième ensemble de vecteurs obtenu en effectuant des mesures de champ magnétique lors de déplacements de seulement environ 18 mètres dans le bâtiment considéré.

Au cours des différentes expériences, la méthode a convergé dans 94% des cas.

Les expériences ainsi conduites ont permis de conclure que la méthode selon la présente divulgation, dans le mode de mise en œuvre présenté ci-dessus, lorsqu'elle converge, permet d'identifier le changement de repère global Tg avec une erreur moyenne de seulement 0,17 m et 1,3° respectivement quant à la translation et la rotation entre le premier et le deuxième repère R1 et R2.

**Revendications**

1. Méthode mise en œuvre par ordinateur de détermination d'au moins une information relative à un changement de repère global (Tg) d'un deuxième repère (R2) associé à un deuxième ensemble de vecteurs (EV2) comprenant de deuxièmes vecteurs (V2j) vers un premier repère (R1) associé à un premier ensemble de vecteurs (EV1) comprenant de premiers vecteurs (V1i), la méthode comprenant les étapes suivantes :

   S10) on obtient lesdits premier et deuxième ensemble de vecteurs (EV1,EV2), le deuxième ensemble de vecteurs étant acquis par des mesures ;

   chaque vecteur étant représentatif d'un champ magnétique dans le monde réel en une position exprimée dans le repère associé à l'ensemble de vecteurs, dite position de mesure ;

une première direction étant considérée comme commune au premier et au deuxième repère (R1,R2) ;

S20) pour chaque deuxième vecteur (V2j), on identifie zéro, un ou une pluralité de premiers vecteurs (V1 i)), dit(s) premier(s) vecteur(s) associé(s), pour lequel ou lesquels une distance entre une représentation (R2j)) du deuxième vecteur (V2j) et une représentation (R1 i)) du premier vecteur (V1i) considéré est inférieure à un seuil d'association ($\delta$) ;

une représentation (R1i, R2j) d'un vecteur étant une valeur obtenue en appliquant une fonction de représentation au vecteur (V1i,V2j) considéré et/ou à la position de mesure (P1i,P2j) associée au vecteur considéré,

la fonction de représentation étant telle que la représentation d'un vecteur est laissée invariante par l'application au vecteur (V1i,V2j) et/ou à la position de mesure (P1i,P2j) associée de toute transformation respectant un ensemble de contrainte ;

l'information à estimer relative au changement de repère global étant une information non fixée par la ou les contraintes de l'ensemble de contrainte ;

l'ensemble de contrainte inclut au moins la contrainte que la transformation conserve au moins la première direction invariante ;

S30) pour chaque association entre un premier vecteur (V1i) et un deuxième vecteur (V2j), on détermine un changement de repère d'association (Tij) respectant la ou les contraintes de l'ensemble de contrainte et optimisant une fonction d'optimisation fonction au moins :

- d'un écart d'alignement entre une direction d'une transformée (Tij(V2j)) du deuxième vecteur (V2j) par le changement de repère d'association (Tij) et une direction du premier vecteur associé (V1i) ; et/ou
- d'un écart de position entre une transformée (Tij(P2j)) de la deuxième position de mesure (P2j) attachée au deuxième vecteur (V2j) par le changement de repère d'association (Tij) et la première position de mesure (P1i) attachée au premier vecteur associé (V1i) ;

S40) on identifie des groupements parmi les changements de repère d'association (Tij) déterminés à l'étape S30 ;
S50) on détermine ladite au moins une information relative au changement de repère global (Tg) en fonction du ou des groupements déterminés à l'étape S40.

2. Méthode selon la revendication 1 dans laquelle pour l'étape S20, les représentations du premier ensemble de vecteurs (EV1) sont enregistrées dans une structure de données prenant en compte leurs positions dans l'espace des représentations, par exemple un arbre d'indexation, notamment un ball-tree, un quad-tree, ou un kd-tree ; et à l'étape S20, on identifie ledit ou lesdits premier(s) vecteur(s) associé(s) en parcourant ladite structure de données.

3. Méthode selon la revendication 1, dans laquelle l'étape S20 comprend les étapes suivantes :

S22) on détermine une partition en voxels de l'espace des représentations ; et
S24) quand les représentations d'un premier et d'un deuxième vecteur appartiennent au même voxel, on associe le premier vecteur et le deuxième vecteur.

4. Méthode selon la revendication 3, dans laquelle l'étape S20 comporte en outre les étapes suivantes :

S25) pour au moins une partie des voxels, on identifie un ou des voxels adjacents ;
S26) quand les représentations d'un premier et d'un deuxième vecteur appartiennent à des voxels adjacents, on associe le premier vecteur et le deuxième vecteur.

5. Méthode selon l'une quelconque des revendications 1 à 4 dans laquelle

à l'étape S20, pour chaque association entre un premier vecteur et un deuxième vecteur, on calcule en outre un coefficient de confiance (Cij) dans l'association déterminée ; et
à l'étape S40 on identifie les groupements en prenant en compte lesdits coefficients de confiance, et/ou à l'étape S50 on détermine au moins en partie le changement de repère global (Tg) en prenant en compte lesdits coefficients de confiance (Cij).

6. Méthode selon l'une quelconque des revendications 1 à 5, dans laquelle chaque représentation (R1i,R2j) comprend, ou est constituée par, une composante représentative d'une norme d'une composante du champ magnétique dans un plan perpendiculaire à la première direction, une composante représentative d'une composante du champ magnétique suivant la première direction, et/ou une composante représentative d'au moins une coordonnée d'une position de mesure.

**7.** Méthode selon l'une quelconque des revendications 1 à 6, dans laquelle chaque représentation (R1i,R2j) comprend, ou est constituée par, une composante représentative du vecteur magnétique (V1i) ou d'une norme du vecteur magnétique (V1i).

**8.** Méthode selon l'une quelconque des revendications 1 à 7, dans laquelle le seuil d'association présente une valeur plus élevée dans des zones dans lesquelles une variation du champ magnétique est forte que dans des zones dans lesquelles une variation du champ magnétique est faible.

**9.** Méthode selon l'une quelconque des revendications 1 à 8, dans laquelle ladite au moins une contrainte de transformation inclut en outre que la transformation soit la combinaison d'une translation de valeur prédéterminée suivant au moins une direction et/ou d'une rotation d'angle de rotation de valeur prédéterminée autour de la première direction.

**10.** Programme d'ordinateur comprenant des instructions qui, lorsque les instructions sont exécutées sur un ordinateur, conduisent l'ordinateur à exécuter les étapes de la méthode selon l'une quelconque des revendications 1 à 9.

**11.** Support de stockage non-volatile lisible par ordinateur sur lequel est enregistré un programme d'ordinateur selon la revendication 10.

**12.** Système comprenant un magnétomètre (M), au moins un processeur (P), et un support d'informations selon la revendication 10, ledit au moins un processeur étant configuré pour enregistrer des mesures de champ magnétiques effectuées par le magnétomètre (M) sur ledit support d'informations.

**Patentansprüche**

**1.** Computerimplementiertes Verfahren zur Bestimmung mindestens einer Information bezüglich einer globalen Bezugspunktänderung (Tg) eines zweiten Bezugspunkts (R2), der einer zweiten Vektorgruppe (EV2) zugeordnet ist, die zweite Vektoren (V2j) zu einem ersten Koordinatensystem (R1), das einer ersten Vektorbaugruppe (EV1) mit ersten Vektoren (V1i) zugeordnet ist, umfasst, wobei das Verfahren die folgenden Schritte umfasst:

S10) es werden die erste und zweite Vektorgruppe (EV1, EV2) erhalten, wobei die zweite Vektorgruppe durch Messungen erfasst wird;

wobei jeder Vektor ein Magnetfeld in der realen Welt an einer Position darstellt, die in dem der Vektorengruppe zugeordneten Bezugspunkt, der Messposition, ausgedrückt wird;
wobei eine erste Richtung als gemeinsam mit dem ersten und zweiten Bezugspunkt (R1,R2) betrachtet wird;

S20) für jeden zweiten Vektor (V2j), werden null, einer oder eine Vielzahl von ersten Vektoren (V1i), zugeordnete erste Vektoren, ermittelt, für die der Abstand zwischen einer Darstellung (R2j) des zweiten Vektors (V2j) und einer Darstellung (R1i) des betrachteten ersten Vektors (V1i) unter einem Zuordnungsschwellenwert ($\delta$) liegt;

wobei eine Darstellung (R1i, R2j) eines Vektors ein Wert ist, der durch Anwenden einer Darstellungsfunktion auf den betrachteten Vektor (V1i, V2j) und/oder auf die dem betrachteten Vektor zugeordnete Messposition (P1i, P2j) erhalten wird,
wobei die Darstellungsfunktion so beschaffen ist, dass die Darstellung eines Vektors durch die Anwendung auf den Vektor (V1i, V2j) und/oder die zugeordnete Messposition (P1i, P2j) jeder Transformation, die eine Gruppe von Beschränkungen erfüllt, unverändert bleibt;
wobei die zu schätzende Information bezüglich der globalen Bezugspunktänderung eine Information ist, die nicht durch die Beschränkung(en) der Beschränkungsgruppe festgelegt ist;
die Gruppe von Beschränkungen mindestens die Beschränkung enthält, dass die Transformation mindestens die erste invariante Richtung beibehält;

S30) für jede Zuordnung zwischen einem ersten Vektor (V1i) und einem zweiten Vektor (V2j) wird eine Änderung des Zuordnungsbezugspunkts (Tij) bestimmt, die die Beschränkung(en) der Beschränkungsgruppe berücksichtigt und eine Optimierungsfunktion von mindestens Folgendem optimiert:

- einer Ausrichtungsabweichung zwischen einer Richtung einer Transformation (Tij(V2j)) des zweiten Vektors (V2j) durch die Änderung des Zuordnungsbezugspunkts (Tij) und einer Richtung des ersten zugehörigen Vektors (V1i); und/oder
- einer Positionsabweichung zwischen einer Transformation (Tij(P2j)) der zweiten Messposition (P2j), die durch die Änderung des Zuordnungsbezugspunkts (Tij) an den zweiten Vektor (V2j) gebunden ist, und der ersten Messposition (P1i), die an den ersten zugeordneten Vektor (V1i) gebunden ist;

S40) es werden Gruppierungen unter den in Schritt S30 bestimmten Änderungen des Zuordnungsbezugspunkts (Tij) ermittelt;

S50) es wird mindestens die eine Information bezüglich der globalen Bezugspunktänderung (Tg) in Abhängigkeit von der oder den in Schritt S40 bestimmten Gruppierungen bestimmt.

2. Verfahren nach Anspruch 1, wobei für Schritt S20 die Darstellungen der ersten Vektorgruppe (EV1) in einer Datenstruktur gespeichert werden, die ihre Positionen im Darstellungsraum berücksichtigt, beispielsweise einem Indizierungsbaum, insbesondere einem Ball-Baum, einem Quad-Baum oder einem kd-Baum; und in Schritt S20 der oder die ersten zugeordneten Vektoren durch Durchlaufen der Datenstruktur ermittelt werden.

3. Verfahren nach Anspruch 1, wobei der Schritt S20 die folgenden Schritte umfasst:

S22) es wird eine Voxelpartition des Darstellungsraums bestimmt; und
S24) wenn die Darstellungen eines ersten und eines zweiten Vektors zu dem selben Voxel gehören, werden der erste Vektor und der zweite Vektor einander zugeordnet.

4. Verfahren nach Anspruch 3, wobei der Schritt S20 ferner die folgenden Schritte aufweist:

S25) für mindestens einen Teil der Voxel werden ein oder mehrere benachbarte Voxel ermittelt;
S26), wenn die Darstellungen eines ersten und eines zweiten Vektors zu benachbarten Voxeln gehören, werden der erste Vektor und der zweite Vektor einander zugeordnet.

5. Verfahren nach einem der Ansprüche 1 bis 4, wobei in Schritt S20 für jede Zuordnung zwischen einem ersten Vektor und einem zweiten Vektor ferner ein Konfidenzkoeffizient (Cij) für die bestimmte Zuordnung berechnet wird; und in Schritt S40 werden die Gruppierungen unter Berücksichtigung der Konfidenzkoeffizienten ermittelt, und/oder in Schritt S50 wird mindestens teilweise die globale Bezugspunktänderung (Tg) unter Berücksichtigung der Konfidenzkoeffizienten (Cij) bestimmt.

6. Verfahren nach einem der Ansprüche 1 bis 5, wobei jede Darstellung (R1i,R2j) eine Komponente, die eine Norm einer Komponente des Magnetfelds in einer zu der ersten Richtung senkrechten Ebene darstellt, eine Komponente, die eine Komponente des Magnetfelds in der ersten Richtung darstellt, und/oder eine Komponente, die mindestens eine Koordinate einer Messposition darstellt, umfasst oder aus diesen besteht.

7. Verfahren nach einem der Ansprüche 1 bis 6, wobei jede Darstellung (R1i, R2j) eine Komponente umfasst oder aus einer Komponente besteht, die den Magnetvektor (V1i) oder eine Norm des Magnetvektors (V1i) darstellt.

8. Verfahren nach einem der Ansprüche 1 bis 7, wobei die Zuordnungsschwelle in Bereichen, in denen eine Magnetfeldänderung stark ist, einen höheren Wert besitzt als in Bereichen, in denen eine Magnetfeldänderung gering ist.

9. Verfahren nach einem der Ansprüche 1 bis 8, wobei die mindestens eine Transformationsbeschränkung ferner enthält, dass die Transformation die Kombination aus einer Translation mit einem vorbestimmten Wert in mindestens einer Richtung und/oder einer Drehung mit einem vorbestimmten Drehwinkel um die erste Richtung ist.

10. Computerprogramm, das Anweisungen umfasst, die, wenn die Anweisungen auf einem Computer ausgeführt werden, den Computer veranlassen, die Schritte des Verfahrens nach einem der Ansprüche 1 bis 9 auszuführen.

11. Nichtflüchtiger, computerlesbarer Speicher, auf dem ein Computerprogramm nach Anspruch 10 gespeichert ist.

**12.** System, das ein Magnetometer (M), mindestens einen Prozessor (P) und einen Informationsträger nach Anspruch 10 umfasst, wobei der mindestens eine Prozessor so eingerichtet ist, dass er Magnetfeldmessungen, die von dem Magnetometer (M) auf dem Informationsträger durchgeführt werden, aufzeichnet.

**Claims**

**1.** A computer-implemented method for determining at least one piece of information relating to a change of global reference frame (Tg) from a second reference frame (R2) associated with a second set of vectors (EV2) comprising second vectors (V2j) to a first reference frame (R1) associated with a first set of vectors (EV1) comprising first vectors (V1i), the method comprising the following steps:

S10) obtaining said first and second sets of vectors (EV1,EV2), the second set of vectors being acquired by measurements;

each vector being representative of a magnetic field in the real world at a position expressed in the reference frame associated with the set of vectors, called a measurement position;
a first direction being considered as common to the first and second reference frames (R1,R2);

S20) for each second vector (V2j), identifying zero, one or a plurality of first vectors (V1i)), so-called first associated vector(s), for which a distance between a representation (R2j)) of the second vector (V2j) and a representation (R1i)) of the first vector (V1i) considered is less than an association threshold ($\delta$);

a representation (R1i, R2j) of a vector being a value obtained by applying a representation function to the vector (V1i,V2j) considered and/or to the measurement position (P1i,P2j) associated with the vector considered,
the representation function being such that the representation of a vector is left invariant by the application to the vector (V1i,V2j) and/or to the measurement position (P1i,P2j) associated of any transformation respecting a set of restrictions;
the piece of information to be estimated relating to the global reference frame change being a piece of information not set by the restriction(s) of the set of restrictions;
the set of restrictions comprises at least the restriction that the transformation keeps at least the first direction invariant;

S30) for each association between a first vector (V1i) and a second vector (V2j), determining a change of association reference frame (Tij) respecting the restriction(s) of the set of restrictions and optimising an optimisation function depending on at least:

- an alignment deviation between a direction of a transform (Tij(V2j)) of the second vector (V2j) by the change of association reference frame (Tij) and a direction of the first associated vector (V1i); and/or
- a position deviation between a transform (Tij(P2j)) of the second measurement position (P2j) linked to the second vector (V2j) by the change of association reference frame (Tij) and the first measurement position (P1i) linked to the first associated vector (V1i);

S40) identifying clusters among the changes of association reference frame (Tij) determined in step S30;
S50) determining said at least one piece of information relating to the change of the global reference frame (Tg) based on the cluster(s) determined in step S40.

**2.** The method according to claim 1, wherein for step S20, the representations of the first set of vectors (EV1) are recorded in a data structure taking their positions in the space of the representations into account, for example an indexing tree, especially a ball-tree, a quad-tree, or a kd-tree; and in step S20, identifying said first associated vector(s) by travelling along said data structure.

**3.** The method according to claim 1, wherein step S20 comprises the following steps:

S22) determining a voxel partition of the space of representations; and
S24) when the representations of a first and a second vector belong to the same voxel, associating the first vector and the second vector.

4. The method according to claim 3, wherein step S20 further comprises the following steps:

   S25) for at least one part of the voxels, identifying one or more adjacent voxels;
   S26) when the representations of a first and a second vector belong to adjacent voxels, associating the first vector and the second vector.

5. The method according to any one of claims 1 to 4, wherein in step S20, for each association between a first vector and a second vector, further calculating a confidence coefficient (Cij) in the association determined; and
   in step S40, identifying the clusters by taking said confidence coefficients into account, and/or in step S50, at least partly determining the global reference change (Tg) by taking said confidence coefficients (Cij) into account.

6. The method according to any one of claims 1 to 5, wherein each representation (R1i,R2j) comprises, or consists of, a component representative of a norm of a component of the magnetic field in a plane perpendicular to the first direction, a component representative of a component of the magnetic field along the first direction, and/or a component representative of at least one coordinate of a measurement position.

7. The method according to any one of claims 1 to 6, wherein each representation (R1i,R2j) comprises, or consists of, a component representative of the magnetic vector (V1i) or a norm of the magnetic vector (V1i).

8. The method according to any one of claims 1 to 7, wherein the association threshold has a higher value in zones in which a magnetic field variation is high than in zones in which a magnetic field variation is low.

9. The method according to any one of claims 1 to 8, wherein said at least one transformation restriction further comprises that the transformation is the combination of a translation with a predetermined value along at least one direction and/or a rotation having an angle of rotation with a predetermined value about the first direction.

10. A computer program comprising instructions which, when the instructions are executed on a computer, cause the computer to execute the steps of the method according to any one of claims 1 to 9.

11. A non-volatile computer-readable storage medium having a computer program according to claim 10 recorded thereon.

12. A system comprising a magnetometer (M), at least one processor (P), and an information medium according to claim 10, said at least one processor being configured to record magnetic field measurements performed by the magnetometer (M) on said information medium.

[Fig. 1]

[Fig. 2]

[Fig. 3]

[Fig. 4]

[Fig. 5]

[Fig. 6]

[Fig. 7]

S10 - Obtention du premier et deuxième ensemble de vecteurs EV1 et EV2

S12 - Acquisition des premier et deuxième ensemble de vecteurs EV1 et EV2

S14 - Echantillonnage des premiers et/ou deuxièmes vecteurs

S20 - Association de premiers vecteurs V1i à de deuxièmes vecteurs V2j

S21 - Détermination des représentations des premiers et deuxièmes vecteurs

S22 - Partition en voxels de l'espace des représentations

S23 - Répartition des premiers et deuxièmes vecteurs dans les différents voxels

S24 - Au sein de chaque voxel, association des premiers et deuxièmes vecteurs du voxel

S25 - Identification des voxels adjacents

S26 - Détermination des associations additionnelles

S30 - Détermination des changements de repère d'associations

S40 - Identification de groupements parmi les changements de repère d'associations

S50 - Détermination du changement de repère global Tg

[Fig. 8]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 5130419 B
- US 9683851 B
- US 8781739 B1
- JP 2009289145 A
- US 2016084659 A1

**Littérature non-brevet citée dans la description**

- **J. COULIN** ; **R. GUILLEMARD** ; **V. GAY-BELLILE** ; **C. JOLY** ; **A. DE L. FORTELLE**. Tightly-Coupled Magneto-Visuallnertial Fusion for Long Term Localization in Indoor Environment. *IEEE Robot. Autom. Lett*, April 2022, vol. 7 (2), 952-959
- **A. SOLIN** ; **S. SARKKA** ; **J. KANNALA** ; **E. RAHTU**. Terrain navigation in the magnetic landscape: Particle filtering for indoor positioning. *2016 European Navigation Conference (ENC)*, May 2016, 1-9
- **H. LUO** ; **F. ZHAO** ; **M. JIANG** ; **H. MA** ; **Y. ZHANG**. Constructing an Indoor Floor Plan Using Crowdsourcing Based on Magnetic Fingerprinting. *Sensors*, November 2017, vol. 17 (11)
- **A. BASIRI et al.** Indoor location based services challenges, requirements and usability of current solutions. *Comput. Sci. Rev*, May 2017, vol. 24, 1-12
- **M. ESTER** ; **H.-P. KRIEGEL** ; **J. SANDER** ; **X. XU**. A Density-Based Algorithm for Discovering Clusters in Large Spatial Databases with Noise. *Proceedings of the 2nd ACM International Conference on Knowledge Discovery and Data Mining*, 1996, 226-231
- **SANDER** ; **JÖRG et al.** Density-based clustering in spatial databases : The algorithm gdbscan and its applications. *Data mining and knowledge discovery*, 1998, vol. 2, 169-194
- **R. BRÉGIER** ; **F. DEVERNAY** ; **L. LEYRIT** ; **J. L. CROWLEY**. Defining the Pose of Any 3D Rigid Object and an Associated Distance. *International Journal of Computer Vision*, June 2018, vol. 126 (6), 571-596
- **E. SCHUBERT** ; **J. SANDER** ; **M. ESTER** ; **H. P. KRIEGEL** ; **X. XU**. DBSCAN Revisited, Revisited: Why and How You Should (Still) Use DBSCAN. *ACM Transactions on Database Systems*, August 2017, vol. 42 (3)